# EUROPEAN PATENT APPLICATION

(11) **EP 2 234 165 A2**
(43) Date of publication of application: **29.09.2010**
(21) Application number: 10002863.8
(22) Date of filing: 18.03.2010
(51) Int. Cl.: H01L 31/0203, H01L 31/18

(54) **Photoelectric transmitting or receiving device and manufacturing method thereof**

(30) Priority: 18.03.2009 TW 87108730; 27.11.2009 TW 87140763
(71) Applicant: Everlight Electronics Co., Ltd., Tucheng City / Taipei County (TW)
(72) Inventor: Lai, Lu-Ming, Tucheng City, Taipei County (TW)
(74) Representative: Michalski Hüttermann & Partner Patentanwälte

(57) **Abstract**

A photoelectric transmitting or receiving device and the manufacturing method thereof are provided. The photoelectric transmitting device comprises a substrate, a first conductive layer, a second conductive layer and a photoelectric transducing chip. The substrate has an upper surface and a recess and is made of a composite material. The recess is defined by a bottom surface and an inner lateral wall extended upwardly from the bottom surface to the upper surface. The first conductive layer and the second conductive layer are formed by using laser to activate the composite material of the substrate. The first conductive layer is disposed on the bottom surface of the recess, and is extended outwardly along the inner lateral wall of the recess and the upper surface of the substrate. The second conductive layer is electrically insulated from the first conductive layer and is extended outwardly along the upper surface of the substrate. The photoelectric transducing chip is disposed on the bottom surface of the recess and electrically connected to the first conductive layer disposed on the bottom surface of the recess and to the second conductive layer, respectively.

## Description

This application claims priority to Taiwan Patent Application No. 098108730 filed on March 18, 2009 and Taiwan Patent Application No. 098140763 filed on November 27, 2009, the disclosures of the latter are incorporated herein by reference in their entirety.

### CROSS-REFEREnCES TO RELATED APPLICATIONS

Not applicable.

### BACKGROUND OF THE INVENTION

### Field of the Invention

The present invention relates to a photoelectric transmitting or receiving device and the manufacturing method thereof, and more particularly, the present invention relates to a photoelectric transmitting or receiving device having a small light scattering angle and the manufacturing method thereof.

### Descriptions of the Related Art

Due to the rapid development of science and technology, lighting devices have evolved continuously from traditional tungsten-filament bulbs to fluorescent lamps, and accordingly, people now have more choices for lighting devices used in daily life. Over recent years, photoelectric transducing chips have found wide application because of advantages, such as low power consumption, a long service life, elimination of warm-up time, rapid response speed and small volume.

In general, a conventional photoelectric transducing chip is disposed on a traditional printed circuit board (PCB) and is electrically connected to form a photoelectric transmitting or receiving device. However, properties of the photoelectric transducing chip determine that light emitted therefrom usually has a large light scattering angle. In applications where concentrated light is needed to illuminate a specific target, a bowl-shaped structure shall be used to concentrate the light beam. Because common printed circuit boards have a limited thickness, an additional reflective cover usually has to be disposed on the circuit board around the photoelectric transducing chip unless an expensive printed circuit board with an extraordinary thickness is used. However, this adds to both the complexity in the manufacturing processes and production costs.

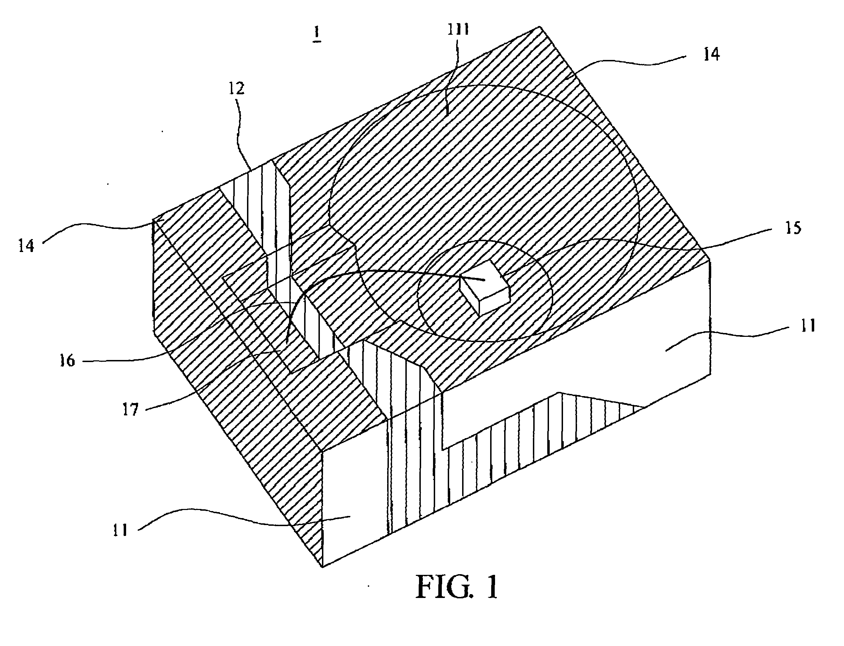

As shown in **FIG. 1****,** to solve this problem, a conventional photoelectric transmitting or receiving device **1** is formed by injecting conductive and nonconductive plastics simultaneously in an injection molding process to form two conductive plastic portions **11** and a nonconductive plastic portion **12** sandwiched therebetween. Afterwards, by using a unique property of metallic-film plating processes, in which a metallic layer can only be plated on conductive objects, two conductive layers **14** are plated on only the two conductive plastic portions **11.** The photoelectric transducing chip **15** is disposed on a bottom of a recess **111** of the photoelectric transmitting or receiving device **1** and electrically connected to one of the conductive layers **14.** Finally, a wire **16** is used to electrically connect the photoelectric transducing chip **15** to the other conductive layer **14.** By using the deep recess **111** plated with the metallic layer (i.e., the conductive layers **14),** the conventional photoelectric transmitting or receiving device **1** is adapted to concentrate light emitted by the photoelectric transducing chip **15,** thereby achieving a small light scattering angle.

It should be particularly noted that the photoelectric transmitting or receiving device **1** shown in **FIG. 1** is mass produced by injection molding a strip of conductive and nonconductive plastics simultaneously and then slicing a strip of photoelectric transmitting or receiving devices **1** that are integrally formed as semi-products into individual photoelectric transmitting or receiving devices **1.** Therefore, the two conductive plastic portions **11** are formed with the conductive layer **14** only on the hatched portions shown in **FIG. 1****,** while those portions without hatched lines are sliced cross-sections that are not formed with the conductive layers **14.** In case the conventional photoelectric transmitting or receiving device **1** is mounted in a vertical orientation (i.e., the device as a whole is mounted perpendicularly to a mounting surface), it must make contact with the mounting surface on its sliced cross-section. However, because the soldering tin and other metal materials for circuit connection are only able to be joined with the conductive layers **14** made of a metal material but unable to be joined tightly with the sliced cross-sections, they are attached only onto the conductive layers **14** at both sides. Consequently, it is difficult to electrically and securely connect or fix the vertically mounted photoelectric transmitting or receiving device **1** by only using the soldering tin, and other means must be used to further fix the photoelectric transmitting or receiving device **1.**

The conventional photoelectric transmitting or receiving device **1** is formed by injection molding conductive plastics and nonconductive plastics simultaneously to form two conductive plastic portions **11** and a nonconductive portion **12** sandwiched therebetween, so it is difficult to control the shapes of the conductive plastic portions **11** and the nonconductive plastic portion **12** accurately. Consequently, it is difficult to further shrink the size of the conventional photoelectric transmitting or receiving device **1.** Accordingly, it is highly desirable in the art to provide a photoelectric transmitting or receiving device featuring a small volume, high reliability and a small light scattering angle.

### SUMMARY OF THE INVENTION

One objective of the present invention is to provide a photoelectric transmitting or receiving device and the manufacturing method thereof. The photoelectric transmitting or receiving device has a small light scattering angle, a further reduced size and improved reliability.

To achieve the aforesaid objective, the photoelectric transmitting or receiving device according to a first embodiment of the present invention comprises a substrate, a first conductive layer, a second conductive layer and a photoelectric transducing chip. The substrate has an upper surface and a recess defined by a bottom and an inner lateral wall extending upwards from the bottom to the upper surface. It should be noted herein that the substrate is made of a composite material, and the composite material is adapted to be formed with a conductive layer on a surface of the composite material by activation with laser irradiation. The first conductive layer is formed by activating the composite material of the substrate with laser irradiation. The first conductive layer is disposed on a first portion of the bottom of the recess and extends outwards along the inner lateral wall of the recess and the upper surface of the substrate. The second conductive layer is also formed by activating the composite material of the substrate with laser irradiation, and is insulated from the first conductive layer. The second conductive layer is disposed on a second portion of the bottom of the recess and extends outwards along the inner lateral wall of the recess and the upper surface of the substrate. The photoelectric transducing chip is disposed on the bottom of the recess and electrically connects with the first conductive layer and the second conductive layer on the bottom of the recess respectively.

The manufacturing method for the photoelectric transmitting or receiving device according to the first embodiment of the present invention comprises the following steps of: (a) providing the substrate, having the upper surface and the recess defined by the bottom and the inner lateral wall extending upwards from the bottom to the upper surface, wherein the substrate is made of a composite material, and the composite material is adapted to be formed with a conductive layer on a surface of the composite material by activation with laser irradiation; (b) laser irradiating the first portion of the bottom of the recess, a portion of the inner lateral wall and a portion of the upper surface of the substrate to form the first conductive layer; (c) laser irradiating the second potion of the bottom of the recess, a portion of the inner lateral wall and a portion of the upper surface of the substrate to form the second conductive layer, wherein the second conductive layer is insulated from the first conductive layer; and (d) disposing a photoelectric transducing chip on the bottom of the recess and electrically connecting the photoelectric transducing chip to the first conductive layer and the second conductive layer on the bottom of the recess respectively.

To achieve the aforesaid objective, the photoelectric transmitting or receiving device according to a second embodiment of the present invention comprises a substrate, a first conductive layer, a second conductive layer and a photoelectric transducing chip. The substrate has an upper surface and a recess. The recess is defined by a bottom and an inner lateral wall extending upwards from the bottom to the upper surface. It should be noted herein that the substrate is made of a composite material, and the composite material is adapted to be formed with a conductive layer on a surface of the composite material by activation with laser irradiation. The first conductive layer is formed by activating the composite material of the substrate with laser irradiation. The first conductive layer is disposed on the bottom of the recess and extends outwards along the inner lateral wall of the recess and the upper surface of the substrate. The second conductive layer is also formed by activating the composite material of the substrate with laser irradiation, and is electrically insulated from the first conductive layer. The second conductive layer is disposed outside the bottom of the recess and extends outwards along the upper surface of the substrate. The photoelectric transducing chip is disposed on the bottom of the recess and electrically connects with the first conductive layer and the second conductive layer respectively.

The manufacturing method for the photoelectric transmitting or receiving device according to the second embodiment of the present invention comprises the following steps of: (a) forming the substrate, having the upper surface and the recess defined by the bottom and the inner lateral wall extending upwards from the bottom to the upper surface; (b) laser irradiating the substrate to form the first conductive layer, wherein the first conductive layer is formed on the bottom of the recess and extends outwards along the inner lateral wall of the recess and the upper surface of the substrate; (c) laser irradiating the substrate to form the second conductive layer, wherein the second conductive layer is formed outside the bottom of the recess, extends outwards along the upper surface of the substrate, and is electrically insulated from the first conductive layer; and (d) disposing the photoelectric transducing chip on the bottom of the recess and electrically connecting the photoelectric transducing chip to the first conductive layer and the second conductive layer respectively.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIG. 1** depicts a conventional photoelectric transmitting or receiving device;
**FIG. 2** is a perspective view of a photoelectric transmitting or receiving device according to a first embodiment of the present invention;
**FIG. 3A** is a front view of the photoelectric transmitting or receiving device according to the first embodiment of the present invention;
**FIG. 3B** is a right side view of the photoelectric transmitting or receiving device according to the first embodiment of the present invention;
**FIG. 3C** is a rear view of the photoelectric transmitting or receiving device according to the first embodiment of the present invention;
**FIG. 3D** is a bottom view of the photoelectric transmitting or receiving device according to the first embodiment of the present invention;
**FIG. 4** is a schematic view of a template during mass production of the photoelectric transmitting or receiving devices according to the first embodiment of the present invention;
**FIG. 5** is a perspective view of a photoelectric transmitting or receiving device according to a second embodiment of the present invention; and
**FIG. 6** is a schematic view of a template during mass production of the photoelectric transmitting or receiving devices according to the second embodiment of the present invention.

### DESCRIPTION OF THE PREFERRED EMBODIMENT

The photoelectric transmitting or receiving device of the present invention is made to have a small size, high reliability and a small light scattering angle by using the Molded Interconnect Device-Laser Direct Structure (MID-LDS) technology. The so-called MID-LDS is a process for molding circuits in which a carrier made of a particular composite material doped with metal atoms is used and irradiated by laser, which disrupts the bonds between the metal atoms in the composite material so that the metal atoms are charged with electrical charges to exhibit a bonding attraction therebetween. Consequently, through a metallization process, a metallic layer can be formed on the laser-treated surface.

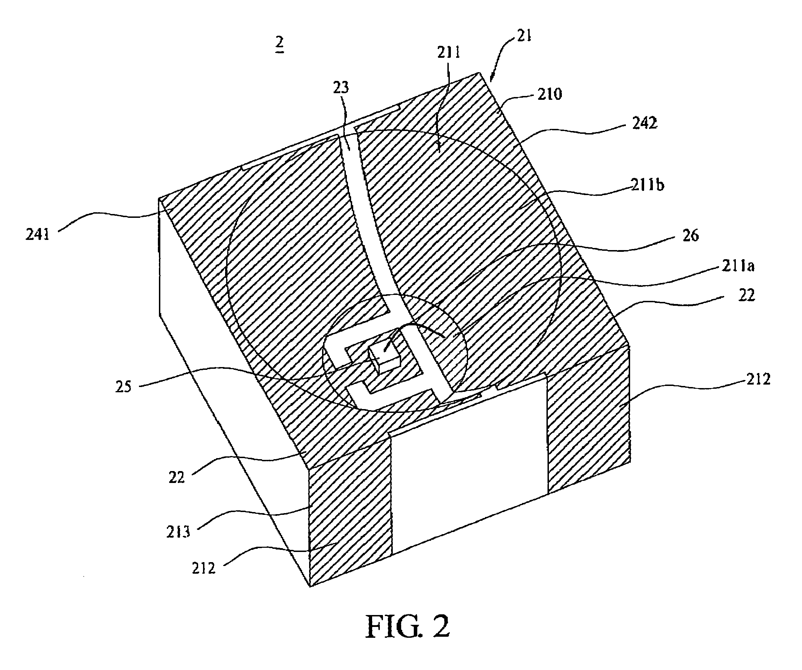

Structure of a photoelectric transmitting or receiving device **2** according to a first embodiment of the present invention that adopts the aforesaid MID-LDS technology is shown in **FIG. 2****.** The photoelectric transmitting or receiving device **2** of the present invention comprises a substrate **21,** two laser treatment regions **22,** a nonconductive region **23** and a photoelectric transducing chip **25.** The substrate **21** has an upper surface **210** and a recess **211** defined by a bottom **211a** and an inner lateral wall **211b** connected with the bottom **211a** and the upper surface **210** of the substrate **21.** The photoelectric transducing chip **25,** which is either a light emitting diode (LED) or a light sensor, is disposed on the bottom **211a** of the recess **211.**

The substrate **21** is made of a composite material used in the aforesaid MID-LDS technology, with the composite material containing doped metal atoms such as copper atoms. Through a laser treatment, two laser treatment regions **22** and a nonconductive region **23** are formed on the substrate **21,** in which the nonconductive region **23** divides the laser treatment regions **22** into two conductive layers of opposite electrical polarities. More specifically, the nonconductive region **23** extends from the upper surface **210** of the substrate **21** downwards to the bottom **211a** of the recess **211,** then across the bottom **211a** of the recess **211,** and finally extends along the inner lateral wall **211b** upwards to the upper surface **210** of the substrate **21.** Hence, the nonconductive region **23** divides the laser treatment regions **22** into a first conductive layer **241** and a second conductive layer **242** electrically insulated from each other. In this embodiment, the first conductive layer **241** is disposed on a first portion of the bottom **211a** of the recess **211** and extends outwards along the inner lateral wall **211b** of the recess 211 and the upper surface **210** of the substrate **21,** while the second conductive layer **242** is disposed on a second portion of the bottom **211a** of the recess **211** and extends outwards along the inner lateral wall **211b** of the recess **211** and the upper surface **210** of the substrate **21.**

The photoelectric transducing chip **25** is disposed on the bottom **211a** of the recess **211** and electrically connected with the first conductive layer **241** and the second conductive layer **242** of the recess **211** respectively. Additionally, it should be noted that the first conductive layer **241** on the bottom **211a** of the recess **211** may be, for example, a die bonding region, with the photoelectric transducing chip **25** being disposed on and electrically connected to the die bonding region, while the second conductive layer **242** may be, for example, a wire bonding region. The photoelectric transducing chip **25** is electrically connected to the wire bonding region via a wire **26.** As the wire **26** of the present invention electrically connects the photoelectric transducing chip **25** and the second conductive layer **242** on the bottom **211a** of the recess **211** through a wire bonding process, the wire bonding and the die bonding process can be accomplished on the bottom **211a** of the recess **211** without having to dispose the wire bonding region outside the recess **211** as in the prior art. Therefore, light generated by the photoelectric transmitting or receiving device of the present invention is well shaped, and as the wire **26** spans a shorter distance as compared to the prior art, it is less liable to fracture and has high reliability. Additionally, a sealing compound (not shown) is disposed in the recess **211** to cover the photoelectric transducing chip **25** and the wire **26.** The sealing compound serves to support the wire **26** and protect the photoelectric transducing chip **25** and the wire **26.**

Furthermore, both the first conductive layer **241** and the second conductive layer **242** of the present invention are of a multi-layer structure which includes a copper plating layer, a nickel plating layer and a gold plating layer in sequence. The copper plating layer is formed on the laser treatment regions **22** through a chemical film-plating process, the nickel plating layer is formed on the copper plating layer through an electroplating process, and the gold plating layer is formed on the nickel plating layer through an electroplating process.

In reference to **FIGS. 2** through **3D****,** by using the MID-LDS process to form the first conductive layer **241** and the second conductive layer **242** through laser irradiation on the laser treatment regions **22,** sites where the conductive layers are formed can be controlled accurately in the photoelectric transmitting or receiving device **2** of the present invention. For the conventional photoelectric transmitting or receiving device **1** which is injection molded, it is difficult to control the formation of the conductive plastic portions **11** and the nonconductive plastic portion **12** accurately, which makes it impossible to further reduce the size thereof. In contrast, the photoelectric transmitting or receiving device **2** of the present invention can not only have the size thereof further reduced, but also allow for shortening of the wire **26** due to the reduced size of the device **2.** With the reduced size, it is easier to apply an adhesive to the wire **26** and the wire **26** is less liable to fracture.

As shown in **FIG. 1****,** the conventional photoelectric transmitting or receiving device **1** is mass produced by injection molding a strip of semi-products in which conductive plastic portions and nonconductive plastic portions are interposed with each other, performing a series of manufacturing processes on the semi-products and finally slicing them into shape. The slicing surfaces are not formed with the conductive layer **14,** and when the conventional photoelectric transmitting or receiving device 1 is to be mounted vertically (i.e., the device as a whole is mounted perpendicularly to the mounting surface), it can only be fixed by the conductive layers **14** and the soldering tin at both sides. In contrast, the photoelectric transmitting or receiving device **2** of the present invention is formed through the MID-LDS process, so the accurate laser irradiation can overcome limitations of the injection molding process used to form the conventional photoelectric transmitting or receiving device **1.** Specifically, in the photoelectric transmitting or receiving device **2** of the present invention, the slicing surfaces are designed to be located on the left and the right sides thereof so that the lateral surface **213** connected with the upper surface **210** of the substrate **21** can be irradiated by the laser to form soldering points **212** thereon. With this arrangement, the photoelectric transmitting or receiving device **2** can be soldered to a printed circuit board (not shown) by means of the soldering points **212** on the lateral surface **213** in a vertical orientation, thereby obtaining a side-emission photoelectric transmitting or receiving device **2.**

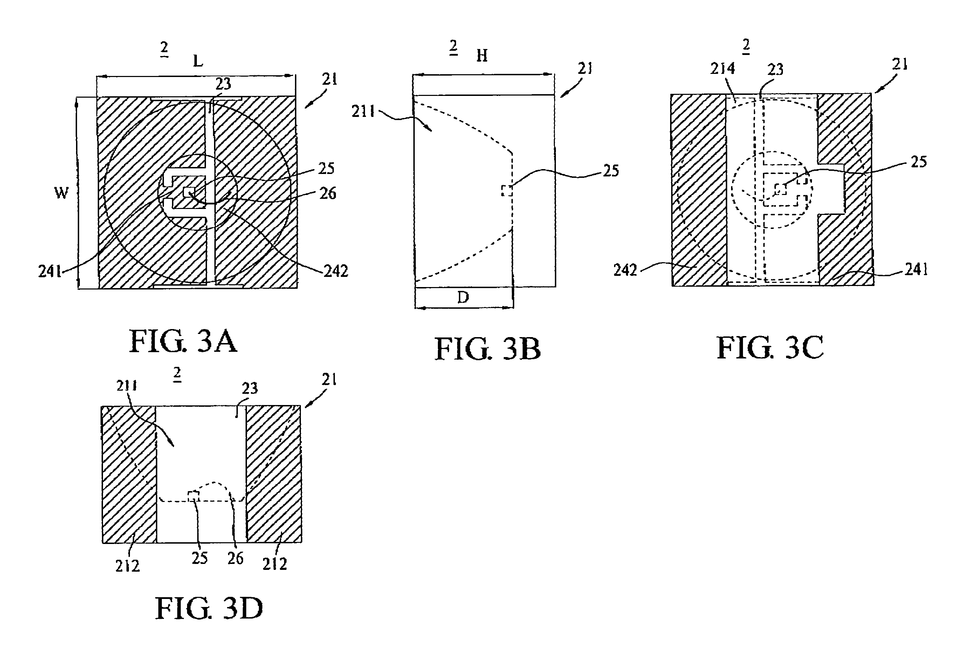

In addition, the first conductive layer **241** and the second conductive layer **242** may extend to the lower surface **214** of the substrate **21** opposite to the upper surface **210** of the substrate **21** as shown in **FIG. 3C****.** Hence, the photoelectric transmitting or receiving device **2** of the present invention may be formed with the soldering points **212** on the lower surface **214** to be soldered to a printed circuit board (not shown) with the recess **211** facing upwards. As a result, the photoelectric transmitting or receiving device **2** may be disposed with the upper surface **210** facing upwards. Additionally, because the area for fixing other circuit bonding materials is enlarged, stability of the fixation is improved remarkably.

In reference to **FIGS. 3A** through **3D****,** as compared to the prior art, the photoelectric transmitting or receiving device **2** is remarkably reduced in size by use of the MID-LDS process, and exhibits a remarkably reduced the light scattering angle owing to the recess **211** which has a large aspect ratio. As compared to the conventional photoelectric transmitting or receiving device **1,** the photoelectric transmitting or receiving device **2** of the present invention is applicable to more miniaturized apparatuses. In a practical application, the photoelectric transmitting or receiving device **2** is adapted to be used as a signal transceiver of a remote controller.

The recess **211** of the photoelectric transmitting or receiving device **2** substantially has a depth **D** of 1.145 mm. The substrate **21** has a length **L,** a width **W** and a thickness **H** parallel to the depth **D** of the recess **211.** The length **L** is substantially 2.3 mm, the width **W** is 2.25 mm and the thickness **H** is 1.6 mm. It should be noted herein that the aforesaid dimensions of the photoelectric transmitting or receiving device **2** of the present invention are only provided as a preferred example but not to limit the scope of the present invention.

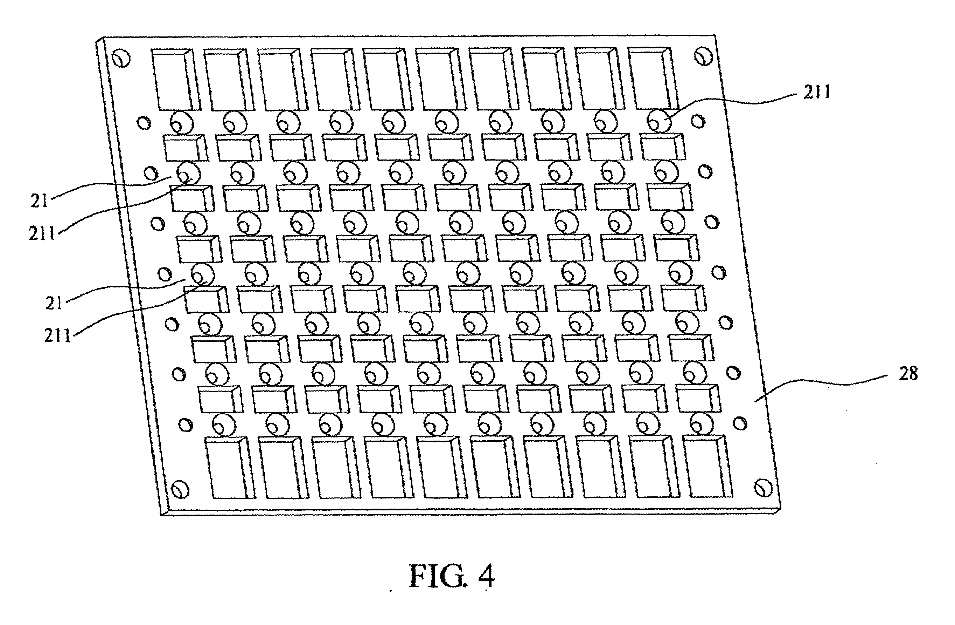

In reference to **FIG. 2****,** the manufacturing method for a photoelectric transmitting or receiving device **2** according to the first embodiment of the present invention will be described now. Initially, step (a) is executed to provide a substrate **21** with an upper surface **210** and formed with a recess **211.** The recess **211** is defined by a bottom **211a** and an inner lateral wall **211b** connected with the bottom **211a** and the upper surface **210** of the substrate **21.** The substrate **21** is made of a composite material, and the composite material is adapted to be formed with a conductive layer on a surface thereof by activation with laser irradiation. In step (a), for mass production, the composite material used in MID-LDS is injected into a mold (not shown) to form a template **28** as shown in **FIG. 4****.** The template **28** comprises a plurality of rows of substrates **21** connected with each other, and each of the substrates **21** has a recess **211.** The template **28** is subjected to subsequent processes and finally sliced into individual photoelectric transmitting or receiving devices 2 separate from each other.

Afterwards, step (b) is executed where a first portion of the bottom **211a** of the recess **211,** a portion of the inner lateral wall **211b** and a portion of the upper surface **210** of the substrate **21** are laser irradiated to form a first conductive layer **241.** Further, in step (c), a second potion of the bottom **211a** of the recess **211,** another portion of the inner lateral wall **211b** and another portion of the upper surface **210** of the substrate **21** are laser irradiated to form a second conductive layer **242.** It should be noted herein that steps (b) and (c) are preferably executed simultaneously; i.e., the two laser treatment regions **22** are laser irradiated simultaneously to form the first conductive layer **241** and the second conductive layer **242** thereon respectively. Additionally, the first conductive layer **241** and the second conductive layer **242** may extend to the lateral surface **213** (which is connected with the upper surface **210** of the substrate **21)** of the substrate **21** to form soldering points **212** thereon so that the photoelectric transmitting or receiving device 2 of the present invention can be mounted vertically. Alternatively, as shown in **FIG. 3C****,** the first conductive layer **241** and the second conductive layer **242** may extend to the lower surface **214** of the substrate **21** opposite to the upper surface **210** of the substrate **21** to be soldered to a printed circuit board (not shown).

The nonconductive region **23** that is not exposed to laser irradiation extends from the upper surface **210** of the substrate **21** downwards to the bottom **211a** of the recess **211,** then across the bottom **211a** of the recess **211,** and finally extends along the inner lateral **wall 211b** of the recess **211** upwards to the upper surface **210** of the substrate **21.** Thus, the nonconductive region **23** divides the laser treatment regions **22** into a first conductive layer **241** and a second conductive layer **242** insulated from each other.

In step (b), the detailed procedure of forming the first conductive layer **241** is as follows: (b1) chemically plating a copper plating layer on one of the laser treatment regions **22** on the substrate **21;** (b2) electroplating a nickel plating layer on the copper plating layer; and (b3) electroplating a gold plating layer on the nickel plating layer. Similarly, in step (c), the detailed procedure of forming the second conductive layer **242** is as follows: (c1) chemically plating a copper plating layer on the other laser treatment region **22** on the substrate **21;** (c2) electroplating a nickel plating layer on the copper plating layer; and (c3) electroplating a gold plating layer on the nickel plating layer. Preferably, in steps (b) and (c), the two copper plating layers of the first conductive layer **241** and the second conductive layer **242** are formed simultaneously, the two nickel plating layers are formed simultaneously and the two gold plating layers are formed simultaneously.

After formation of the first conductive layer **241** and the second conductive layer **242,** a photoelectric transducing chip **25** is disposed on the bottom **211a** of the recess **211** and electrically connected to the first conductive layer **241** and the second conductive layer 242 on the bottom **211a** of the recess **211** respectively in step (d).

Subsequent to step (d), the manufacturing method of the present invention further comprises step (e) where a sealing compound is applied to cover the photoelectric transducing chip **25** and the wire **26.** The wire **26** spans a smaller distance and, correspondingly, the length along which the sealing compound must be applied is decreased, and the application of the sealing compound in the photoelectric transmitting or receiving device **2** of the present invention can be performed easier and more reliably than in the conventional photoelectric transmitting or receiving device **1**.

After completion of the aforesaid processes, a slicing process is finally performed to slice the template **28** shown in **FIG. 4** into individual photoelectric transmitting or receiving devices **2,** thereby obtaining the photoelectric transmitting or receiving device **2** shown in **FIG. 2****.** Detailed dimensions of the photoelectric transmitting or receiving device **2** formed by the manufacturing method of the present invention have been described above and thus will not be described herein again. In the present invention, the aforesaid slicing direction is parallel to a direction in which the nonconductive region **23** extends, so when an individual photoelectric transmitting or receiving device **2** thus obtained is mounted vertically, the lateral surface **213** thereof is formed with the soldering points **212** of the first conductive layer **241** and the second conductive layer **242** that are adapted to be bonded with soldering tin or other metal bonding materials. The soldering points **212** may further extend from the first conductive layer **241** and the second conductive layer **242** to the lower surface **214** of the substrate **21** opposite to the upper surface **210,** so when mounted in a horizontal orientation, the photoelectric transmitting or receiving device **2** is adapted to be joined with a printed circuit board on the lower surface **214,** with the recess **211** facing upwards. Accordingly, as compared to the conventional photoelectric transmitting or receiving device **1,** the photoelectric transmitting or receiving device **2** may be fixed more securely. The aforesaid detailed structure of the first embodiment is not intended to limit the photoelectric transmitting or receiving device of the present invention, and the primary objective of the present invention is still to incorporate the use of the MID-LDS technology.

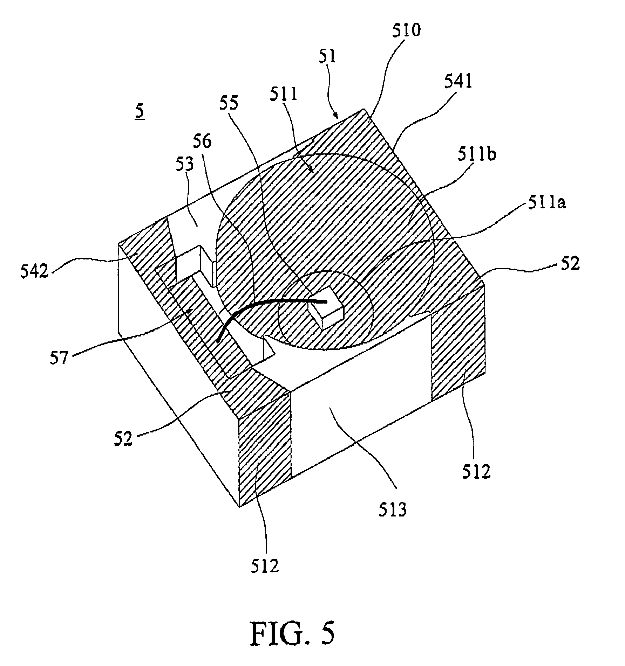

Please refer to **FIG. 5****,** it depicts the structure of a photoelectric transmitting or receiving device **5** according to a second embodiment of the present invention. Similar to the first embodiment, the photoelectric transmitting or receiving device **5** comprises a substrate **51,** two laser treatment regions **52,** a nonconductive region **53** and a photoelectric transducing chip **55.** The substrate **51** has an upper surface **510** and a recess **511** defined by a bottom **511a** and an inner lateral wall **511b** extending from the bottom **511a** upwards to the upper surface **510** of the substrate **51.** The photoelectric transducing chip **55,** which may be an LED, a light sensor or a combination thereof, is disposed on the bottom **511a** of the recess **511.** The same components as those of the first embodiment just have the same functions as described in the first embodiment, and thus will not be described herein again. However, the differences lie in: (1) the position where the conductive layer is disposed; and (2) the substrate **51** further comprising a groove **57.**

Specifically, as in the first embodiment, the substrate **51** is also made of a composite material used in the aforesaid MID-LDS technology, with the composite material containing doped metal atoms such as copper atoms. Through a laser treatment, two laser treatment regions **52** and a nonconductive region **53** are formed on the substrate **51.** The nonconductive region **53** divides the laser treatment regions **52** into two conductive layers of opposite electrical polarities. It should be particularly noted that the difference from the first embodiment lies in that: the first conductive layer **541** is disposed on the bottom **511a** of the recess **511** and, preferably, all over the bottom **511a** of the recess **511;** and the second conductive layer **542** is disposed at least on the upper surface **510** of the substrate **51** outside the bottom **511a** of the recess **511** and, preferably, completely outside the recess **511.**

Similarly, the photoelectric transducing chip **55** is disposed on the bottom **511a** of the recess **511** and electrically connected with the first conductive layer **541** and the second conductive layer **542** of the recess **511** respectively. In more detail, the first conductive layer **541** on the bottom **511a** of the recess **511** may be, for example, a die bonding region, with the photoelectric transducing chip **55** being disposed on and electrically connected to the die bonding region, while the second conductive layer **542** may be, for example, a wire bonding region. Therefore, the photoelectric transducing chip **55** is electrically connected to the wire bonding region via a wire **56.** However, the difference from the first embodiment lies in that the upper surface **510** of the substrate **51** in the second embodiment is further formed with a groove **57** for the connection between the recess **511** and the wire bonding region (i.e., the second conductive layer **542),** so that the wire **56** connects the photoelectric transducing chip **55** and the wire bonding region via the groove **57.**

Similar to the first embodiment, in the photoelectric transmitting or receiving device **5** according to the second embodiment of the present invention, the slicing surfaces can also be designed to be located on the left and the right sides thereof so that the lateral surface **513** connected with the upper surface **510** of the substrate **51** can be irradiated by the laser to form soldering points **512** thereon. Accordingly, the photoelectric transmitting or receiving device **5** can be soldered to a printed circuit board (not shown) by means of the soldering points **512** on the lateral surface **513** in a vertical orientation, thereby obtaining a side-emission photoelectric transmitting or receiving device **5.** In addition, the first conductive layer **541** and the second conductive layer **542** further extend to a lower surface of the substrate **51** opposite to the upper surface **510.** Hence, the photoelectric transmitting or receiving device **5** of the present invention may be formed with the soldering points **512** on the lower surface to be soldered to a printed circuit board (not shown) with the recess **511** facing upwards. As a result, the photoelectric transmitting or receiving device **5** of the second embodiment may be disposed with the upper surface **510** facing upwards. Additionally, because the area for fixing other circuit bonding materials is enlarged, stability of the fixation is improved remarkably.

Additionally, a sealing compound (not shown) may also be disposed in the recess **511** and the groove **57** to cover the photoelectric transducing chip **55** and the wire **56.** The sealing compound serves to support the wire **56** and protect the photoelectric transducing chip **55** and the wire **56.** Furthermore, both the first conductive layer **541** and the second conductive layer **542** of the second embodiment are also of a multi-layer structure which includes a copper plating layer, a nickel plating layer and a gold plating layer in sequence. The copper plating layer is formed on the laser treatment regions **52** of the substrate **51** through a chemical film-plating process, the nickel plating layer is formed on the copper plating layer through an electroplating process, and the gold plating layer is formed on the nickel plating layer through another electroplating process.

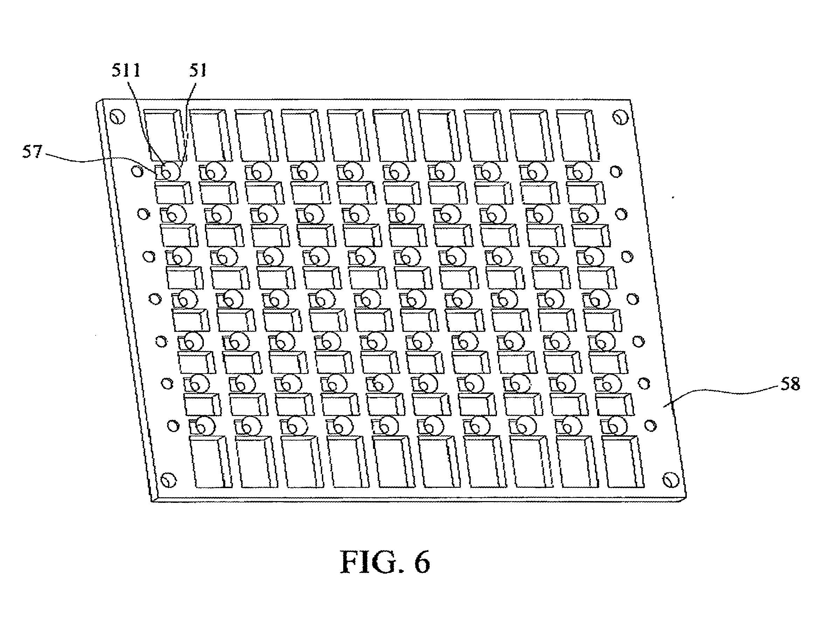

Similarly, in reference to **FIG. 5****,** the manufacturing method for a photoelectric transmitting or receiving device **5** according to the second embodiment of the present invention will be described hereafter. Initially, step (a) is executed to provide a substrate **51,** which has an upper surface **510** and is formed with a recess **511** and a groove **57.** The recess **511** is defined by a bottom **511a** and an inner lateral wall **511b** connected with the bottom **511a** and the upper surface **510** of the substrate **51.** The substrate **51** is made of a composite material, and the composite material is adapted to be formed with a conductive layer on a surface thereof by activation with laser irradiation. In step (a), for mass production, the composite material used in MID-LDS is injected into a mold (not shown) to form a template **58** as shown in **FIG. 6****.** The difference between the template **58** and the template **28** shown in **FIG. 4** is that the template **58** further comprises the grooves **57.** Similarly, the template **58** comprises a plurality of rows of substrates **51** connected with each other, and each of the substrates **51** has a recess **511 and** a groove **57.** The template **58** is subjected to subsequent processes and finally sliced into individual photoelectric transmitting or receiving devices **5** separate from each other.

Afterwards, step (b) is executed where the bottom **511a** of the recess **511,** the inner lateral wall **511b** of the recess **511** and the upper surface **510** of the substrate **51** are laser irradiated to form a first conductive layer **541.** Preferably, in step (b), the entire bottom **511a** of the recess **511** is laser irradiated. Further, in step (c), the upper surface **510** of the substrate **51** outside the bottom **511a** of the recess **511** is laser irradiated to form a second conductive layer **542.** Preferably, in step (c), the upper surface **510** of the substrate **51** outside the entire recess **511** is laser irradiated to form the second conductive layer **542.** It should be noted herein that steps (b) and (c) are preferably executed simultaneously; i.e., the two laser treatment regions **52** are laser irradiated simultaneously to form the first conductive layer **541** and the second conductive layer **542** thereon respectively.

Additionally, the first conductive layer **541** and the second conductive layer **542** may extend to the lateral surface **513** (which is connected with the upper surface **510** of the substrate **51)** of the substrate **51** to form soldering points **512** thereon, so that the photoelectric transmitting or receiving device **5** of the present invention can be mounted vertically. The first conductive layer **541** and the second conductive layer **542** further extend to the lower surface opposite to the upper surface **510** of the substrate **51** to be soldered to a printed circuit board (not shown).

In step (b), the detailed procedure of forming the first conductive layer **541** is as follows: (b1) chemically plating a copper plating layer on one of the laser treatment regions **52** on the substrate **51;** (b2) electroplating a nickel plating layer on the copper plating layer; and (b3) electroplating a gold plating layer on the nickel plating layer. Similarly, in step (c), the detailed procedure of forming the second conductive layer **542** is as follows: (c1) chemically plating a copper plating layer on the other laser treatment region **52** on the substrate **51;** (c2) electroplating a nickel plating layer on the copper plating layer; and (c3) electroplating a gold plating layer on the nickel plating layer. Preferably, in steps (b) and (c), the two copper plating layers of the first conductive layer **541** and the second conductive layer **542** are formed simultaneously, the two nickel plating layers are formed simultaneously and the two gold plating layers are formed simultaneously.

After formation of the first conductive layer **541** and the second conductive layer **542,** a photoelectric transducing chip **55** is disposed on the bottom **511a** of the recess **511** and electrically connected to the first conductive layer **541** on the bottom **511a** of the recess **511** and the second conductive layer **542** respectively in step (d). Subsequent to step (d), the manufacturing method of the present invention further comprises step (e) where a sealing compound is applied into the recess **511** and the groove **57** to cover the photoelectric transducing chip **55** and the wire **56.**

After completion of the aforesaid processes, a slicing process is finally performed to slice the template **58** shown in **FIG. 6** into individual photoelectric transmitting or receiving devices **5,** thereby obtaining the photoelectric transmitting or receiving device **5** of the present invention shown in **FIG. 5****.** The slicing method is identical to that of the first embodiment and, thus, will not be described herein again.

According to the above descriptions, by utilizing the MID-LDS technology, the photoelectric transmitting or receiving device and the manufacturing method thereof of the present invention make an improvement on the drawbacks of conventional photoelectric transmitting or receiving devices, thereby resulting in a simpler manufacturing process, a smaller volume, a smaller light scattering angle and lower costs. Moreover, the photoelectric transmitting or receiving devices of the present invention are adapted to be injection molded using the same set of molds and then irradiated by laser with different designed patterns to produce products of different designs, thereby significantly improving the diversity of the product designs without replacing the molds.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A photoelectric transmitting or receiving device, comprising:
a substrate, having an upper surface and a recess defined by a bottom and an inner lateral wall extending upwards from the bottom to the upper surface, wherein the substrate is made of a composite material, and the composite material is adapted to be formed with a conductive layer on a surface of the composite material by activation with laser irradiation;
a first conductive layer, disposed on a first portion of the bottom of the recess and extending outwards along the inner lateral wall of the recess and the upper surface of the substrate, wherein the first conductive layer is formed by activating the composite material of the substrate with laser irradiation;
a second conductive layer, insulated from the first conductive layer, disposed on a second portion of the bottom of the recess and extending outwards along the inner lateral wall of the recess and the upper surface of the substrate, wherein the second conductive layer is formed by activating the composite material of the substrate with laser irradiation; and
a photoelectric transducing chip, disposed on the bottom of the recess and electrically connecting with the first conductive layer and the second conductive layer on the bottom of the recess, respectively.

2. A photoelectric transmitting or receiving device, comprising:
a substrate, having an upper surface and a recess defined by a bottom and an inner lateral wall extending upwards from the bottom to the upper surface, wherein the substrate is made of a composite material, and the composite material is adapted to be formed with a conductive layer on a surface of the composite material by activation with laser irradiation;
a first conductive layer, disposed on the bottom of the recess and extending outwards along the inner lateral wall of the recess and the upper surface of the substrate, wherein the first conductive layer is formed by activating the composite material of the substrate with laser irradiation;
a second conductive layer, insulated from the first conductive layer, disposed outside the bottom of the recess and extending outwards along the upper surface of the substrate, wherein the second conductive layer is formed by activating the composite material of the substrate with laser irradiation; and
a photoelectric transducing chip, disposed on the bottom of the recess and electrically connecting with the first conductive layer and the second conductive layer, respectively.

3. The photoelectric transmitting or receiving device as claimed in claim 1 or 2, wherein the photoelectric transmitting or receiving device further comprises a plurality of soldering points disposed on a lateral surface of the substrate, the lateral surface is connected with the upper surface of the substrate and adapted to be joined with a surface of a circuit board, and the soldering points extend from the first conductive layer and the second conductive layer.

4. The photoelectric transmitting or receiving device as claimed in claim 1 or 2, wherein the composite material comprises a composite material applied in MID-LDS.

5. The photoelectric transmitting or receiving device as claimed in claim 1, wherein the first conductive layer on the bottom of the recess is a die bonding region, the second conductive layer on the bottom of the recess is a wire bonding region, the photoelectric transducing chip is disposed on the die bonding region and electrically connected to the die bonding region, and the photoelectric transducing chip is electrically connected to the wire bonding region via a wire.

6. The photoelectric transmitting or receiving device as claimed in claim 2, wherein the first conductive layer on the bottom of the recess is a die bonding region, the second conductive layer is a wire bonding region, the photoelectric transducing chip is disposed on the die bonding region and electrically connected to the die bonding region, and the photoelectric transducing chip is electrically connected to the wire bonding region via a wire.

7. The photoelectric transmitting or receiving device as claimed in claim 6, wherein the substrate is further formed with a groove connecting with the recess and the wire bonding region, and the wire connects with the photoelectric transducing chip and the wire bonding region via the groove.

8. The photoelectric transmitting or receiving device as claimed in claim 1 or 2, wherein the photoelectric transmitting or receiving device further comprises a sealing compound covering the photoelectric transducing chip and the wire.

9. The photoelectric transmitting or receiving device as claimed in claim 1 or 2, wherein the photoelectric transducing chip is a light emitting diode or a light sensor.

10. The photoelectric transmitting or receiving device as claimed in claim 1 or 2, wherein each of the first conductive layer and the second conductive layer further comprises a copper plating layer formed on the substrate.

11. The photoelectric transmitting or receiving device as claimed in claim 10, wherein each of the first conductive layer and the second conductive layer further comprises a nickel plating layer formed on the copper plating layer.

12. The photoelectric transmitting or receiving device as claimed in claim 11, wherein each of the first conductive layer and the second conductive layer further comprises a gold plating layer formed on the nickel plating layer.

13. A manufacturing method for a photoelectric transmitting or receiving device, comprising the following steps of:
(a) providing a substrate, having an upper surface and a recess defined by a bottom and an inner lateral wall extending upwards from the bottom to the upper surface, wherein the substrate is made of a composite material, and the composite material is adapted to be formed with a conductive layer on a surface of the composite material by activation with laser irradiation;
(b) laser irradiating a first portion of the bottom of the recess, a portion of the inner lateral wall and a portion of the upper surface of the substrate to form a first conductive layer;
(c) laser irradiating a second portion of the bottom of the recess, a portion of the inner lateral wall and a portion of the upper surface of the substrate to form a second conductive layer, wherein the second conductive layer is insulated from the first conductive layer; and
(d) disposing a photoelectric transducing chip on the bottom of the recess and electrically connecting the photoelectric transducing chip to the first conductive layer and the second conductive layer on the bottom of the recess respectively.

14. The manufacturing method as claimed in claim 13, wherein the composite material comprises a composite material applied in Molded Interconnect Device-Laser Direct Structure (MID-LDS).

15. The manufacturing method as claimed in claim 13, wherein the step (b) comprises the following steps of:
(b1) chemically plating a copper plating layer.
(b2) electroplating a nickel plating layer on the copper plating layer.
(b3) electroplating a gold plating layer on the nickel plating layer.

16. The manufacturing method as claimed in claim 13, wherein the step (c) comprises the following steps of:
(c1) chemically plating a copper plating layer.
(c2) electroplating a nickel plating layer on the copper plating layer.
(c3) electroplating a gold plating layer on the nickel plating layer.electro

17. The manufacturing method as claimed in claim 13, wherein the first conductive layer on the bottom of the recess is a die bonding region, the second conductive layer on the bottom of the recess is a wire bonding region, and in the step (d), the photoelectric transducing chip is disposed on the die bonding region and electrically connected to the die bonding region, and the photoelectric transducing chip is electrically connected to the wire bonding region via a wire.

18. The manufacturing method as claimed in claim 13, wherein the manufacturing method further comprises the following step after the step (d):
(e) applying a sealing compound to cover the photoelectric transducing chip and the wire.

19. The manufacturing method as claimed in claim 13, wherein the first conductive layer or the second conductive layer further extends to form a soldering point, the soldering point is disposed on a lateral surface of the substrate, and the lateral surface is connected with the upper surface of the substrate.

20. A manufacturing method for a photoelectric transmitting or receiving device, comprising the following steps of:
(a) forming a substrate, having an upper surface and a recess defined by a bottom and an inner lateral wall extending upwards from the bottom to the upper surface, wherein the substrate is made of a composite material, and the composite material is adapted to be formed with a conductive layer on a surface of the composite material by activation with laser irradiation;
(b) laser irradiating the substrate to form a first conductive layer, wherein the first conductive layer is formed on the bottom of the recess and extends outwards along the inner lateral wall of the recess and the upper surface of the substrate;
(c) laser irradiating the substrate to form a second conductive layer, wherein the second conductive layer is formed outside the bottom of the recess, extends outwards along the upper surface of the substrate and insulated from the first conductive layer; and
(d) disposing a photoelectric transducing chip on the bottom of the recess and electrically connecting the photoelectric transducing chip to the first conductive layer on the bottom of the recess and to the second conductive layer respectively.

21. The manufacturing method as claimed in claim 20, wherein in the steps (b) and (c), the first conductive layer or the second conductive layer further extends to a lateral surface of the substrate to form a plurality of soldering points, and the lateral surface is connected with the upper surface of the substrate and adapted to be joined with a surface of a circuit board.

22. The manufacturing method as claimed in claim 21, wherein the composite material comprises a composite material applied in MID-LDS.

23. The manufacturing method as claimed in claim 22, wherein the first conductive layer on the bottom of the recess is a die bonding region, the second conductive layer is a wire bonding region, and in the step (d), the photoelectric transducing chip is disposed on the die bonding region and electrically connected to the die bonding region, and the photoelectric transducing chip is electrically connected to the wire bonding region via a wire.

24. The photoelectric transmitting or receiving device as claimed in claim 23, wherein in the step (a), the substrate is further formed with a groove connecting with the recess and the wire bonding region, and the wire connects with the photoelectric transducing chip and the wire bonding region via the groove.

25. The manufacturing method as claimed in claim 24, wherein the manufacturing method further comprises the following step after the step (d):
(e) applying a sealing compound to cover the photoelectric transducing chip and the wire.

26. The manufacturing method as claimed in claim 20, wherein the step (b) comprises the following steps of:
(b1) chemically plating a copper plating layer on the substrate;
(b2) electroplating a nickel plating layer on the copper plating layer; and
(b3) electroplating a gold plating layer on the nickel plating layer.

27. The manufacturing method as claimed in claim 20, wherein the step (c) comprises the following steps of:
(c1) chemically plating a copper plating layer on the substrate;
(c2) electroplating a nickel plating layer on the copper plating layer; and
(c3) electroplating a gold plating layer on the nickel plating layer.
